(19) Europäisches Patentamt
European Patent Office
Office européen des brevets

(11) **EP 3 899 554 B1**

(12) **EUROPÄISCHE PATENTSCHRIFT**

(45) Veröffentlichungstag und Bekanntmachung des Hinweises auf die Patenterteilung:
**23.08.2023  Patentblatt 2023/34**

(21) Anmeldenummer: **20706987.3**

(22) Anmeldetag: **14.02.2020**

(51) Internationale Patentklassifikation (IPC):
**G01R 15/14** *(2006.01)*        **G01R 31/08** *(2020.01)*

(52) Gemeinsame Patentklassifikation (CPC):
**G01R 31/085; G01R 15/142;** G01R 15/202;
G01R 15/205; G01R 15/207

(86) Internationale Anmeldenummer:
**PCT/EP2020/053880**

(87) Internationale Veröffentlichungsnummer:
**WO 2020/169468 (27.08.2020 Gazette 2020/35)**

(54) **VERFAHREN ZUM ÜBERWACHEN EINER STROMLEITUNG**

METHOD FOR MONITORING A POWER LINE

PROCÉDÉ DE SURVEILLANCE D'UNE LIGNE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.02.2019  EP 19158605**

(43) Veröffentlichungstag der Anmeldung:
**27.10.2021  Patentblatt 2021/43**

(73) Patentinhaber: **Siemens Energy Global GmbH & Co. KG**
**81739 München (DE)**

(72) Erfinder:
• ENGEL, Thomas
  73432 Aalen (DE)
• BIRCHBAUER, Josef Alois
  8054 Seiersberg (AT)

(56) Entgegenhaltungen:
EP-A1- 2 495 166        US-A1- 2015 225 002
US-A1- 2015 353 196

EP 3 899 554 B1

**Beschreibung**

Die Erfindung betrifft ein Verfahren zum Überwachen einer einen elektrischen Strom führenden Stromleitung, eine mobile Inspektionsvorrichtung, ein Computerprogramm und ein maschinenlesbares Speichermedium.

Die Offenlegungsschrift US 2015/0225002 A1 offenbart eine Drohne umfassend einen Sensor und eine Kamera. Die Drohne fährt einem Zug voraus und inspiziert die dem Zug vorausliegenden Gleise.

Die Offenlegungsschrift US 2015/0353196 A1 offenbart eine Drohne umfassend einen Sensor, welcher ein elektromagnetisches Feld einer Überlandleitung erfassen beziehungsweise messen kann.

Die Offenlegungsschrift EP 2 495 166 A1 offenbart eine Drohne umfassend mehrere Sensoren sowie ein Kamerasystem.

Die Offenlegungsschrift DE 10 2015 221 600 A1 offenbart ein Verfahren zum Überwachen und Verwalten eines Stromverteilungssystems. Das bekannte Verfahren umfasst ein Empfangen von Sensormessdaten, die von einer mobilen Inspektionsvorrichtung während einer Inspektion eines Stromverteilungssystemelements in einem Stromverteilungssystem erfasst werden. Die mobile Inspektionsvorrichtung umfasst Infrarotkameras und Audiosensoren, die eingerichtet sind, elektrische Resonanzen, Brummen oder Vibrationen zu erfassen.

Die der Erfindung zugrunde liegende Aufgaben ist darin zu sehen, ein Konzept zum effizienten Überwachen einer einen elektrischen Strom führenden Stromleitung bereitzustellen.

Diese Aufgabe wird mittels des jeweiligen Gegenstands der unabhängigen Ansprüche gelöst. Vorteilhafte Ausgestaltungen der Erfindung sind Gegenstand von jeweils abhängigen Unteransprüchen.

Nach einem ersten Aspekt wird ein Verfahren zum Überwachen einer einen elektrischen Strom führenden Stromleitung unter Verwendung einer mobilen Inspektionsvorrichtung bereitgestellt, wobei die mobile Inspektionsvorrichtung einen Magnetfeldsensor und eine Kamera umfasst, umfassend die folgenden Schritte:

Messen eines durch den Strom erzeugten Magnetfelds mittels des Magnetfeldsensors und

Aufnehmen eines Bildes der Stromleitung mittels der Kamera in Abhängigkeit des gemessenen Magnetfelds, wobei der elektrische Strom ein Wechselstrom ist, wobei basierend auf dem gemessenen Magnetfeld eine Phase und/oder eine Frequenz des elektrischen Stroms ermittelt wird, wobei die Kamera das Bild basierend auf der ermittelten Phase und/oder der ermittelten Frequenz aufnimmt.

Nach einem zweiten Aspekt wird eine mobile Inspektionsvorrichtung zum Überwachen einer einen elektrischen Strom führenden Stromleitung bereitgestellt, umfassend:

einen Magnetfeldsensor, welcher eingerichtet ist, einen durch den Strom erzeugtes Magnetfeld zu messen, und eine Kamera, welche eingerichtet ist, ein Bild der Stromleitung in Abhängigkeit des gemessenen Magnetfelds aufzunehmen, wobei der elektrische Strom ein Wechselstrom ist, wobei basierend auf dem gemessenen Magnetfeld eine Phase und/oder eine Frequenz des elektrischen Stroms ermittelt wird, wobei die Kamera das Bild basierend auf der ermittelten Phase und/oder der ermittelten Frequenz aufnimmt.

Nach einem dritten Aspekt wird ein Computerprogramm nach Anspruch 12 bereitgestellt.

Nach einem vierten Aspekt wird ein maschinenlesbares Speichermedium bereitgestellt, auf dem das Computerprogramm nach dem dritten Aspekt gespeichert ist.

Die Erfindung basiert auf der Erkenntnis, dass Isolationsschäden in einer einen elektrischen Strom führenden Stromleitung zu Spannungsüberschlägen führen können. Solche Spannungsüberschläge können von einem oder mehreren Lichtblitzen begleitet werden. Solche Lichtblitze können effizient mittels einer Kamera aufgenommen werden, so dass hierüber in vorteilhafter Weise ermöglicht ist, Isolationsschäden effizient zu erfassen.

Spannungsüberschläge hängen insbesondere von dem durch die Stromleitung fließenden elektrischen Strom ab. Der durch die Stromleitung elektrische Strom erzeugt ein Magnetfeld, welches von dem elektrischen Strom abhängt. Über eine Messung des Magnetfelds mittels des Magnetfeldsensors können somit in vorteilhafter Weise Informationen, zum Beispiel eine Phase, eine Frequenz (bei einem Wechselstrom) und/oder eine Stromstärke, über den elektrischen Strom gewonnen werden. Basierend auf diesen Informationen kann zum Beispiel effizient ermittelt werden, an welchem Ort der Stromleitung und/oder zu welchem Zeitpunkt mit einem Spannungsüberschlag und somit mit einem Lichtblitz gerechnet werden kann, sofern die Stromleitung an diesem Ort einen Isolationsschaden aufweist. Dadurch ist es zum Beispiel in vorteilhafter Weise ermöglicht, die Kamera basierend auf dem Ort und/oder Zeitpunkt zu betreiben, um einen Lichtblitz aufnehmen zu können. Das heißt also, dass vorgesehen ist, die Kamera basierend auf dem gemessenen Magnetfeld zu betreiben, um einen Lichtblitz aufnehmen zu können, welcher aus einem möglichen Isolationsschaden resultiert.

Somit wird der technische Vorteil bewirkt, dass die Stromleitung effizient überwacht werden kann.

In einer Ausführungsform ist die mobile Inspektionsvorrichtung ein Element ausgewählt aus der folgenden Gruppe von Fahrzeugen: Landfahrzeug, Wasserfahrzeug, Luftfahrzeug. Ein Luftfahrzeug ist zum Beispiel eine Drohne.

Die mobile Inspektionsvorrichtung ist nach einer Ausführungsform eingerichtet, ferngesteuert zu werden.

Die mobile Inspektionsvorrichtung ist nach einer Ausführungsform zusätzlich oder anstelle zur Fernsteuerung für einen autonomen Betrieb eingerichtet.

In einer Ausführungsform sind mehrere Magnetfeldsensoren und/oder sind mehrere Kameras vorgesehen. Ausführungen, die im Zusammenhang mit einer Kamera und/oder einem Magnetfeldsensor gemacht sind, gelten analog für mehrere Kameras und/oder mehrere Magnetfeldsensoren und umgekehrt.

Bei mehreren Magnetfeldsensoren sind diese gleich oder unterschiedlich. Bei mehreren Kameras sind diese gleich oder unterschiedlich.

Erfindungsgemäß ist vorgesehen, dass der elektrische Strom ein Wechselstrom ist.

Erfindungsgemäß ist vorgesehen, dass der elektrische Strom ein Wechselstrom ist, wobei basierend auf dem gemessenen Magnetfeld eine Phase und/oder eine Frequenz des elektrischen Stroms ermittelt wird, wobei die Kamera das Bild basierend auf der ermittelten Phase und/oder der ermittelten Frequenz aufnimmt.

Dadurch wird zum Beispiel der technische Vorteil bewirkt, dass das Bild effizient aufgenommen werden kann. Spannungsüberschläge treten in der Regel in der Nähe eines Maximums einer Netzspannung, welche bei einem Wechselstrom eine Wechselspannung ist, auf, welche für ein Fließen des elektrischen Stroms verantwortlich ist. Über die Phase und/oder der Frequenz des Wechselstroms können somit in vorteilhafter Weise ein Ort und/oder ein Zeitpunkt ermittelt werden, an welchem bei einem Isolationsschaden an diesem Ort ein Spannungsüberschlag und somit ein Lichtblitz auftreten könnte. Die Kamera kann somit effizient betrieben werden, um zum Beispiel zum ermittelten Zeitpunkt und/oder am ermittelten Ort eine Aufnahme anzufertigen.

Nach einer Ausführungsform ist vorgesehen, dass das Aufnehmen eines Bildes ein Mehrfachbelichten eines Frames umfasst.

Dadurch wird zum Beispiel der technische Vorteil bewirkt, dass auch ein Lichtblitz mit geringer Lichtintensität effizient erfasst werden kann.

Gemäß einer weiteren Ausführungsform ist vorgesehen, dass das Aufnehmen ein Belichten mehrerer individueller Frames umfasst, welche addiert werden.

Dadurch wird zum Beispiel der technische Vorteil bewirkt, dass auch ein Lichtblitz mit geringer Lichtintensität effizient erfasst werden kann.

Nach einer Ausführungsform ist vorgesehen, dass die mehreren Frames zur Addition zueinander verschoben werden, um eine Bewegung der mobilen Inspektionsvorrichtung auszugleichen.

Dadurch wird zum Beispiel der technische Vorteil bewirkt, dass eine Bewegung der mobilen Inspektionsvorrichtung effizient ausgeglichen werden kann.

Die Addition der mehreren Frames wird zum Beispiel unter Verwendung eines Stitching-Verfahrens durchgeführt.

In einer Ausführungsform ist vorgesehen, dass für das Aufnehmen des Bildes nur ein bestimmter Teilbereich eines Bildsensors der Kamera in Abhängigkeit einer Ausrichtung des Magnetfeldsensors relativ zur Stromleitung ausgelesen wird.

Dadurch wird zum Beispiel der technische Vorteil bewirkt, dass weniger Daten verarbeitet werden müssen verglichen mit dem Fall, dass der gesamte Bildsensor ausgelesen wird.

Es wird also insbesondere ein "Region of Interest (ROI)", auf Deutsch ein Bereich von Interesse (hier der bestimmte Teilbereich), als auszulesenden Bereich des Bildsensors basierend auf der Ausrichtung des Magnetfeldsensors relativ zur Stromleitung ermittelt.

In einer Ausführungsform umfasst die Kamera einen Bildsensor.

In einer Ausführungsform ist die Kamera eine UV-Kamera. Die Kamera ist also vorzugsweise eingerichtet, elektromagnetische Strahlung im Ultraviolett (UV)- Bereich zu erfassen. Die Kamera ist also insbesondere eingerichtet, UV-Bilder aufzunehmen.

Dadurch wird zum Beispiel der technische Vorteil bewirkt, dass der Lichtblitz effizient erfasst werden kann. Denn ein solcher Lichtblitz weist üblicherweise einen hohen Anteil an UV-Strahlung auf.

In einer Ausführungsform ist vorgesehen, dass die mobile Inspektionsvorrichtung zumindest einen akustischen Sensor (,also einen oder mehrere akustische Sensoren,) umfasst, mittels welchem ein Luftschall gemessen wird, wobei der gemessene Luftschall basierend auf der ermittelten Phase und/oder der ermittelten Frequenz ausgewertet wird, um ein aus einem Spannungsüberschlag resultierendes akustisches Signal zu detektieren.

Dadurch wird zum Beispiel der technische Vorteil bewirkt, dass Isolationsschäden effizient erfasst oder detektiert werden können. Spannungsüberschläge sind in der Regel von akustischen Emissionen begleitet, welche als akustisches Signal mittels des akustischen Sensors erfasst werden können. Analog zum Lichtblitz hängen diese akustischen Emissionen vom Spannungsüberschlag und hierüber vom elektrischen Strom ab, so dass analog zum Lichtblitz über ein Messen des Magnetfelds, welches vom fließenden elektrischen Strom erzeugt wird, eine Aussage darüber getroffen werden kann, an welchem Ort und/oder zu welchem Zeitpunkt mit einem akustischen Signal gerechnet werden kann.

Bei einem Wechselstrom wird das akustische Signal zum Beispiel mit einem Maximum der Netzspannung korrelieren. Mit anderen Worten, ein akustisches Signal, welches zum Beispiel zu einem Minimum der Netzspannung um das Potenzial Null gemessen wurde, kann nicht von einem Spannungsüberschlag herrühren.

Nach einer Ausführungsform ist vorgesehen, dass mehrere akustische Sensoren vorgesehen sind, wobei basierend auf dem jeweiligen gemessenen Luftschall eine Triangulation durchgeführt wird, um eine Quelle des akustischen Signals zu orten.

Dadurch wird zum Beispiel der technische Vorteil bewirkt, dass eine Quelle des akustischen Signals effizient geortet werden kann. Es wird also eine Quelle des akustischen Signals basierend auf der Durchführung der Triangulation geortet. Ein Orten bedeutet, dass eine Position oder ein Ort oder eine Richtung in Bezug zur mobilen Inspektionsvorrichtung an der Stromleitung ermittelt wird.

In einer Ausführungsform ist vorgesehen, dass eine Phasenlage des elektrischen Stroms zum Zeitpunkt des detektierten Spannungsüberschlags ermittelt wird, wobei basierend auf der ermittelten Phasenlage und einer Nominalspannung der Stromleitung eine Durchbruchspannung ermittelt wird.

Dadurch wird zum Beispiel der technische Vorteil bewirkt, dass eine Defektschwere eines Isolationsschadens effizient ermittelt werden kann.

In einer Ausführungsform ist vorgesehen, dass das aufgenommene Bild ausgewertet wird, um einen Spannungsüberschlag zu detektieren, wobei bei Detektion eines Spannungsüberschlags die mobile Inspektionsvorrichtung und/oder die Kamera derart gesteuert werden, dass ein Ort einer Quelle des detektierten Spannungsüberschlags weiter mittels der Kamera aufgenommen werden kann.

Dadurch wird zum Beispiel der technische Vorteil bewirkt, dass der Ort der Quelle des detektierten Spannungsüberschlags effizient erfasst und weiter untersucht werden kann.

In einer Ausführungsform ist vorgesehen, dass basierend auf dem gemessenen Magnetfeld Steuersignale zum Steuern einer Bewegung der mobilen Inspektionsvorrichtung erzeugt und ausgegeben werden, um die mobile Inspektionsvorrichtung entlang eines Verlaufs der Stromleitung zu bewegen.

Dadurch wird zum Beispiel der technische Vorteil bewirkt, dass die mobile Inspektionsvorrichtung effizient entlang des Verlaufs der Stromleitung bewegt werden kann.

In einer Ausführungsform ist die Stromleitung eine Hochspannungsleitung.

Die Stromleitung weist gemäß einer Ausführungsform eine Isolierung auf.

Die Stromleitung ist nach einer Ausführungsform eine Überlandleitung.

Die Stromleitung ist nach einer Ausführungsform Teil eines Bündels aus Stromleitungen, beispielsweise aus drei Stromleitungen.

Eine Netzfrequenz beträgt nach einer Ausführungsform 50 Hz oder 60 Hz.

In einer Ausführungsform ist die mobile Inspektionsvorrichtung nach dem zweiten Aspekt eingerichtet, das Verfahren nach dem ersten Aspekt auszuführen.

Technische Funktionalitäten der mobilen Inspektionsvorrichtung nach dem zweiten Aspekt ergeben sich unmittelbar aus entsprechenden technischen Funktionalitäten des Verfahrens nach dem ersten Aspekt und umgekehrt.

Vorrichtungsmerkmale ergeben sich somit unmittelbar aus entsprechenden Verfahrensmerkmalen und umgekehrt.

Im Folgenden wird beispielhaft eine Überwachung eine Hochspannungsleitung als einen elektrischen Strom führende Stromleitung gemäß dem hier beschriebenen Konzept beschrieben.

Bekannte mobile Inspektionsvorrichtungen umfassen zum Beispiel GPS-Sensoren oder auch Inertialsensoren, um die Bewegung der Inspektionsvorrichtung zu erfassen, um Positionsinformationen für eine Steuerung, bei einer Drohne zum Beispiel für eine Flugsteuerung, zu erstellen. Die Steuerung steuert dann die Inspektionsvorrichtung über eine Bahnregelung von einer Istposition auf einer Sollbahn einer geplanten Trajektorie.

Die mobile Inspektionsvorrichtung nach dem zweiten Aspekt verwendet insbesondere zudem mindestens ein weiteres Messsignal vom Messobjekt (hier die Hochspannungsleitung), um die Steueraufgabe einer aktiven und gegebenenfalls automatischen Verfolgung des Messobjektes mit höherer Genauigkeit zu erfüllen.

Im Falle der Hochspannungsleitung, die beispielsweise mit einer Netzfrequenz von 50 Hz oder 60 Hz betrieben wird, fließt ein elektrischer Wechselstrom. Dieser erzeugt ein elektromagnetisches Feld, das von mindestens einem Magnetfeldsensor der mobilen Inspektionsvorrichtung erfasst wird.

Das zu messende (elektro)magnetische Signal ergibt sich folgendermaßen:
Die Hochspannungsleitungen haben beispielsweise 3 Phasen, die zueinander 120° in der Phase versetzt sind. Je nach Land ist die Netzfrequenz bei 50 oder 60 Hz. Das heißt, dass die elektrische Spannung und folglich auch der elektrische Strom in den Leitungen mit 50 oder 60 Hz moduliert ist. Da eine Schwingung eine positive und eine negative Halbwelle hat, die jeweils ein Maximum haben, treten 50 oder 60 mal 2 Maxima, also 100 oder 120 Maxima auf. Hier verdoppelt sich also die Frequenz, wenn die Energie oder die Leistung betrachtet wird. Es gilt, dass $\text{Sin}^2(x) = \frac{1}{2}(\text{Sin}(2x) + 1)$.

Das Verschieben der 2 vom Exponenten in das Argument vom Sinus ist genau die Frequenzverdopplung, die den Übergang von der Amplitude der elektrischen Wechselspannung auf die elektrische Leistung darstellt.

Somit kann sich die mobile Inspektionsvorrichtung mit einem hinreichend schnellen Magnetfeldsensor auch an die Funktion der Hochspannungsleitung funktional ankoppeln. Dies weist den technischen Vorteil auf, dass funktionale Schäden, insbesondere Isolationsschäden, die Spannungsüberschläge zur Folge haben, detektiert werden können.

Diese Spannungsüberschläge sind meist begleitet von einem Lichtblitz, der aufgrund der Anregung und Ionisierung von Luftmolekülen große Anteile UV-Strahlung enthält. Die UV-Strahlung des Lichtblitzes kann zum Nachweis eines Corona Effektes verwendet werden. Dazu können UV-Kamera(s) eingesetzt werden.

Das heißt, dass die Corona mit der doppelten Netzfrequenz beobachtbar, also detektierbar, ist, solange der Durchbruch nicht aufgrund irgendwelcher Effekte eine Asymmetrie aufweist. Dann könnte es sein, dass man ihn nur mit der einfachen Netzfrequenz sieht.

Wegen der 3 zueinander versetzten Phasen ist es dann so, dass in einem kompletten Schwingungszyklus der Spannung, also den 20 ms bei 50 Hz in jeder Phase der Leitung 2 Maxima, in Summe also 6 Maxima, auftreten. Diese sind zeitlich gleich verteilt. Das heißt, dass zum Beispiel vorgesehen ist, in 20 ms 6 Bilder aufzunehmen, was einer Bildfolge von 300 Hz entspricht. Bei den 60 Hz Netzfrequenz sind es dann sogar 360 Hz, also immer ein Faktor 2 für jede Phase und das mal Anzahl der Phasen als Faktor zur Netzfrequenz. Macht bei 3 Phasen dann Faktor 6.

Im Folgenden wird weiter erläutert werden, wann es im Zyklus zu einer ausgeprägten Corona kommt. Ohne jetzt weiter im Detail die Plasmaphysik zu behandeln, sollen dennoch einige grundlegende Effekte oder Ursachen wie folgt erläutert werden.

Die Corona ist ein Spannungsdurchschlag in der Luft. Der Spannungsüberschlag kann ab einer gewissen Spannung (die Durchbruchspannung) abhängig von einer Größe des Defekts in der Isolation auftreten. Kleinere Defekte werden dann erst bei höheren Spannungen auftreten. Maximale Empfindlichkeit hat man also in der Nähe des Maximums der Netzspannung - für jede der Phasen getrennt zu betrachten! Jeder Isolator sitzt ja nur in einer Phase. Je nach Stärke des Defekts zündet die Corona bei einer bestimmten Spannung. In dem Lichtbogen wird dann die Luft ionisiert, was weitere Ionen und damit weitere leitfähige Ionen produziert. Es erhöht sich so die Leitfähigkeit in der ionisierten Luft, die Ionen bewegen sich im elektrischen Feld. Dabei stoßen sie mit anderen Molekülen zusammen. Insgesamt kommt es dann zu Anregungen von atomaren Elektronen in angeregte Zustände in den Luftmolekülen, also vorwiegende von Stickstoff und Sauerstoff. Wenn die angeregten Zustände dann wieder zerfallen, geben die strahlenden Übergänge einen Lichtblitz ab, was aufgrund der Vielzahl der Vorgänge zur Corona wird. Da die Ionen aufgrund des Spannungsdurchbruchs in der Luft die Leitfähigkeit der Luft erhöhen, bleibt die Corona noch bestehen, wenn die Spannung in der Leitung schon wieder abfällt. Somit ist der Coronaeffekt zeitlich zum Maximum versetzt und etwas verzögert.

Daraus folgt, dass die Belichtung der Kamera vorteilhafterweise insbesondere mit oder (sehr) kurz vor dem Maximum der Netzspannung auf der Leitung einer der Phasen beginnt. Insbesondere liegt ein Beginn der Belichtung 1/3 der Belichtungszeit vor und/oder insbesondere 2/3 der Belichtungszeit nach dem Maximum.

Damit die Informationen (Phase der Hochspannungsleitung und die Schwingungs- oder Netzfrequenz) für die Belichtung der Kamera zur Verfügung stehen, ist eine Messung des Magnetfeldes vorgesehen unter Verwendung eines Magnetfeldsensors.

Eine Messung eines Magnetfelds mittels eines Magnetfeldsensors basiert zum Beispiel auf dem Hall-Effekt und/oder dem magnetoresistiven (MR) Effekt, beispielsweise dem AMR (anisotroper magnetoresistiver)-Effekt und/oder dem GMR (Giant Magnetoresistive)-Effekt. Magnetfeldsensoren, welche auf dem GMR-Effekt basieren, haben viele Vorteile und sind durch Automobilindustrie robuste Massenware und sehr günstig. Die haben auch den Vorteil, dass implizit eine Temperatur gemessen kann und diese in der Messung sich sogar dann wieder aufhebt. Somit steht eine multifunktionale Sensorik für indirekte Magnetfeldmessungen zur Verfügung.

Ein weiterer technischer Effekt ist, dass die magnetoresistiven Magnetfeldsensoren in einer Ebene bereits eine Feldrichtung des Magnetfelds messen. Hall-Sensoren messen nur eine Projektion des Magnetfeldes auf einen Halbleiterbaustein des Hall-Sensors in einer Richtung senkrecht zur Stromrichtung. Es braucht also insbesondere 2 Hall-Sensoren, um einen MR-Sensor zu ersetzen.

In einer Ausführungsform ist vorgesehen, dass mindestens 2 MR-Sensoren verwendet werden, wobei diese derart angeordnet sind, dass im Raum eine 3D-Feldrichtung gemessen werden kann.

Die MR-Sensoren sind auch schnell, also können diese auch die Frequenz des magnetischen Feldes und somit die Netzfrequenz effizient messen.

Insbesondere ist als ein Magnetfeldsensor ein optischer quanten-Magnetfeldsensor vorgesehen, der in vorteilhafter Weise sehr empfindlich ist und somit für das hier beschriebenen Konzept sehr geeignet ist.

MR- und Hall-Sensoren weisen weiter den Vorteil eines geringen Energieverbrauchs auf.

Das magnetische Feld um einen langgestreckten Leiter, als der eine Hochspannungsleitung approximiert werden kann, zeigt sich in konzentrischen Ringen um den Leiter, wo von Halbwelle zu Halbwelle sich dann die Richtung der Feldlinien umkehrt.

Das heißt, der Leiter ist senkrecht auf der Ebene einer Feldlinie, also in der Normalenebene der Feldrichtung am Messort. Misst man also an zwei Orten die Feldrichtung, schneiden sich die Normalenebenen in der Achse des Leiters, wenn das Feld nicht durch Dielektrika uns Störeffekte verzerrt ist. Dass keine Verzerrung bei Luft stattfindet, wird vorliegend als erste Näherung angenommen.

Für die Messung des Magnetfelds ist gemäß einer Ausführungsform vorgesehen, dass die mobile Inspektionsvorrichtung zwei Magnetfeldsensoren mit bekannter räumlicher Anordnung und Orientierung aufweist. Dann lässt sich über Triangulation der Ort der Hochspannungsleitung bestimmen und so auch der Abstand zur Inspektionsvorrichtung einfach über die Winkelbeziehung der Feldrichtungen in der Messebene ermitteln.

Die Feldrichtung wechselt dann von Phase zu Phase der Hochspannungsleitung, da ja die einzelnen Leiter in der Hochspannungsleitung räumlich getrennt sind und sich die Feldstärke sinusförmig moduliert. Das wird beispielsweise bei der Auswertung berücksichtigt.

Mit dieser Information zur Phase kann dann zum Beispiel die Kamera getriggert werden und schon können die Bilder zum passenden Zeitpunkt, wo auch in der jeweiligen Phase eine Corona-Entladung zu erwarten ist, effizient aufgenommen werden.

Sofern die Kamera beispielsweise keine Aufnahmegeschwindigkeit (framerate) von 300 Hz aufweist, ist zum Beispiel vorgesehen, dass die Triggerung intelligent genutzt wird und die Aufnahmegeschwindigkeit der Kamera geschickt ausgenutzt wird derart, dass möglichst schnell hintereinander die 6 Zeitpunkte zur Netzphase erwischt werden und so wenig wie möglich Wartezeit zwischen den Frames besteht. Da die zeitlichen Abstände von einem Peak zum nächsten nur gut 3 ms sind, sollte man max. mal 6 ms warten müssen, was bei rund 160 Hz framerate liegt. Ist die Kamera noch langsamer, fällt das Warten zeitlich nicht mehr wirklich ins Gewicht.

Da die Intensität der UV-Strahlung einer Corona gering und der Abstand zur Kamera eher größer ist, wird das Licht in der Regel nur aus einem sehr kleinen und damit geringen Raumwinkel erfasst. Somit kann es erforderlich sein, dass ein Kamerabild über mehrere mögliche Corona-Entladungen integriert wird. Das kann auf mehrere Arten durchgeführt werden:

a) Brute force: Vergrößern der Belichtungszeit.

b) Mehrfachbelichtung eines Frames immer zu den Zeitpunkten, wo man eine Corona erwartet, um so das Signal-Rausch-Verhältnis (SNR) zu optimieren. Jede der Phasen der Leitung hat dann andere Zeitpunkte für die Corona.

c) Schnelle Belichtung individueller frames, die dann nachfolgend addierte werden, um so das SNR zu optimieren und das Ausleserauschen über Mittelung zu minimieren.

d) Wie c) nur dass die Frames zur Addition noch zueinander verschoben werden, um so die Bewegungseffekte der Inspektionsvorrichtung ausgleichen zu können, der sich typischerweise mit einer gleichförmigen Bewegung am Messobjekt (hier die Hochspannungsleitung) entlang bewegt. Damit kann die Lokalisierung des Signals verbessert werden. Dies Addition der Teilbilder zum Gesamtbild kann dann mit einem oder mehreren Stitching-Methoden erfolgen.

e) Bei c) und d) können dann auch die Informationen des Magnetfeldsensors verwendet werden, um zu bestimmen, welche Phase gerade aktiv und nahe beim Maximum ist, da nur da eine Corona auftreten wird. Wenn der Magnetfeldsensor zu der (UV)-Kamera in bekannter Weise ausgerichtet ist, können so aus einem Bildsensor der Kamera nur die Bereiche als Region of Interest (ROI) ausgelesen werden, die zu dem Winkelbereich passen, in dem eine Corona auftreten kann. Über die Nutzung von ROI kann ein Bildsensor der Kamera mit deutlich höherer Geschwindigkeit ausgelesen werden, was dann insbesondere bei c) und d) sehr hilft. Die Lage des ROI kann sich dann aufgrund der Magnetfeldmessung je nach Güte einer Bahnregelung der Inspektionsvorrichtung dann auch noch dynamisch von frame zu frame ändern.

Durch das Messen des magnetischen Felds und der Feldrichtung ist es in vorteilhafter Weise ermöglicht, zu bestimmen, welche Stromleitung oder welches Leitungsbündel (bei mehreren Leitungsbündeln) momentan ein maximales Magnetfeld aufweist.

Dadurch gewinnt man eine Information, in welchem Bereich eines Bildes nach einem Lichtblitz gesucht werden muss, da ja auch eine Kamera eigentlich nur ein Winkelsensor ist für eine Strahlrichtung. Koppelt man also - über den Aufbau - den Magnetfeldsensor, zum Beispiel den MR-Sensor, mit der Kamera, zum Beispiel mit der UV-Kamera, kann der der Magnetfeldsensor der Kamera die Information bereitstellen, in welcher Bildhöhe ein Corona-Effekt zu erwarten ist. Schnelle und auch echtzeitfähige Defekterkennung werden möglich - zum Beispiel über gekoppelte FPGA basierte Bildauswertung in der mobilen Inspektionsvorrichtung selbst.

Aufgrund der Magnetfelddaten kann dann dem FPGA eine Richtungsinformation bereitgestellt werden, der diese dann für eine ROI-Auswertung im Bild nutzt. Weniger Daten auswerten und auslesen und verarbeiten reduziert einen elektrischen Energieverbrauch der mobilen Inspektionsvorrichtung und kann somit einen Energiespeicher, zum Beispiel einen Akkumulator, der Inspektionsvorrichtung schonen.

Somit kann zum Beispiel der technische Effekt bewirkt werden, dass eine Reichweite der Inspektionsvorrichtung effizient erhöht werden kann.

Das schnelle Erkennen des Defektes weist zudem den technischen Vorteil auf, dass unmittelbar nach Defekterkennung eine Nahaufnahme des Defekts aufgenommen werden kann, um eine sofortige Detailkontrolle durchzuführen. Hier kann zum Beispiel in einer Steuerung der Inspektionsvorrichtung eine Nahaufnahmebewegungsbahn hinterlegt sein, welche bei Defekterkennung automatisch abgeflogen oder abgefahren wird.

So kann in vorteilhafter Weise eine zeitnahe Auswertung mit geringer Latenz durchgeführt werden.

Isolationsdefekte, die in der Regel die kritischsten Fehler oder Defekte sind, können somit schnell und sicher erkannt werden. Isolationsdefekte bringen sofort auch Leitungsverluste mit sich und kosten damit unmittelbar sofort Geld für den Netzbetreiber. Auch diese Nachteile können minimiert werden aufgrund der schnellen Defekterkennung.

In einer Ausführungsform sind mehrere Magnetsensoren vorgesehen, welche jeweils für sich eine Feldrichtung des magnetischen Felds messen, so dass basierend auf den jeweiligen gemessenen Feldrichtungen eine Triangulation durchgeführt wird, um einen Ort oder eine Position der Stromleitung zu ermitteln und optional zusätzlich um einen Abstand zu der oder den Stromleitungen zu ermitteln. Basierend auf dem Ort der Stromleitung und optional auf dem Abstand wird zum Beispiel eine Bewegung der Inspektionsvorrichtung gesteuert. Bei einem Luftfahrzeug wird zum Beispiel ein Flug, insbesondere eine Höhe und eine Lage, gesteuert.

So kann zum Beispiel ein Abstand zu der Stromleitung konstant gehalten werden, so dass die Stromleitung unabhängig von einer eventuellen Durchbiegung aufgenommen werden kann, was so einer annähernd kontanten Größe der einzelnen Bauteile im Bild führt. Das verbessert die Aufnahme und das Verarbeiten der Messdaten oder Messsignale weiter. Ferner sind die Signale des Magnetfeldsensors einfacher und mit geringerem Rechenaufwand auszuwerten als eine Bildauswertung, was bei der begrenzten elektrischen Energie einer mobilen Inspektionsvorrichtung dann größere Reichweiten bei gleicher Akkukapazität ermöglicht.

In einer Ausführungsform ist vorgesehen, dass die Auswertung der Magnetfeldmessung und die Auswertung des aufgenommenen Bildes noch während eines Betriebs der mobilen Inspektionsvorrichtung durchgeführt werden, was auch als "on the fly" (bei einem Luftfahrzeug) oder "live"-Auswertung bezeichnet werden kann. Dies weist zum Beispiel den technischen Vorteil auf, dass das aufgenommene Bild kein Stereobild sein muss. Es reicht vielmehr ein Monobild. Die Kamera kann also eine Monokamera sein und muss keine Stereokamera sein. Über das Bild kann eine Orientierung stattfinden und das Magnetsignal kann für ein Ermitteln eines Abstands und einer Richtung zur Stromleitung verwendet werden.

In einer Ausführungsform ist die Kamera eine TOF-Kamera. Hier wird also mittels der Kamera eine Time of flight"-Messung durchgeführt. "Time of flight" kann mit "Laufzeit" übersetzt werden. Es wird also eine Laufzeitmessung durchgeführt. Das erhöht auch eine Datensicherheit durch ein unabhängiges Messprinzip.

In einer Ausführungsform ist vorgesehen, dass die mobile Inspektionsvorrichtung einen verstellbaren Kamerahalter umfasst, an welchem die Kamera befestigt ist.

In einer Ausführungsform ist vorgesehen, dass der verstellbare Kamerahalter basierend auf dem aufgenommenen Bild und/oder basierend auf dem gemessenen Magnetfeld derart angesteuert wird, dass ein bestimmter Bereich oder ein bestimmter Ort im Bild gehalten wird, also im Aufnahmebereich der Kamera gehalten wird.

Eine solche aktive Regelung ermöglicht in vorteilhafter Weise, dass die Sicherheitsbereiche am Bildrand gegen ungewolltes Abschneiden verringert werden können, so dass entweder bei gleicher Sensorgröße der Kamera die Vergrößerung und damit die Auflösung erhöht werden kann oder die Sensorgröße reduziert werden kann, um so die Datenmenge zu reduzieren.

In einer Ausführungsform umfasst die mobile Inspektionsvorrichtung einen akustischen Sensor, der beispielsweise kapazitiv, induktiv, piezoelektrisch oder optisch aufgebaut sein kann, zur Erfassung des Luftschalls.

Dadurch wird insbesondere der technische Vorteil bewirkt, dass eine Corona auch akustisch detektiert werden kann. Da bei der Entladung die Luft durch die Entladung kurzzeitig stark aufgeheizt wird, kommt es auch zu akustischen Signalen. Diese können dann effizient mit dem Schallsensor detektiert werden.

In einer Ausführungsform ist vorgesehen, dass die Phasenlage der Wechselspannung verwendet wird, die mittels des Magnetfeldsensors ermittelt wird, um einen Zeitpunkt zu ermitteln, wann die Corona akustisch mittels des akustischen Sensors detektiert werden kann. Es ist also ein Abschätzen aufgrund der konkreten Phasenlage der Wechselspannung vorgesehen, bei welcher Phasenlage vor einem Maximum der Spannung oder der Energie des Magnetfelds ein Durchbruch stattfindet. Es ist insbesondere vorgesehen, dass der ermittelte Zeitpunkt der Schalldetektion eines Durchbruchs (und/oder einer Corona) korrigiert wird, um eine Laufzeit des Schalls von der betreffenden Stromleitung oder einer Gruppe von Stromleitungen (Bündel) zum Schallsensor (akustischer Sensor) oder zur mobilen Inspektionsvorrichtung zu berücksichtigen. So kann in vorteilhafter Weise eine Messgenauigkeit weiter gesteigert werden.

Es gilt:

```
t_Corona = t_Schallsignal – Distanz_Inspektionsvorrichtung-
Stromleitung / Schallgeschwindigkeit,
```

wobei t Corona der Zeitpunkt des Auftretens der Corona ist, wobei t Schallsignal der Zeitpunkt des Detektierens des Schallsignals ist, wobei Distanz Inspektionsvorrichtung-Stromleitung die Distanz zwischen der Inspektionsvorrichtung (oder dem Schallsensor) und der Stromleitung oder der Gruppe von Stromleitungen ist.

Die Phasenlage der Corona (Phase_Corona) ergibt sich dann über die Beziehung:
Phase Corona = 2 * Pi * t Corona * Netzfrequenz, wenn im Fall, dass t Corona = 0 ist, die Amplitude der Wechselspannung einen Nulldurchgang durchläuft.

In einer Ausführungsform ist die nominale Spannung der Stromleitung bekannt. Dadurch kann in vorteilhafter Weise die Durchbruchspannung effizient abgeschätzt werden und so effizient eine Schwere oder Größe des Defekts bestimmt werden.

In einer Ausführungsform ist vorgesehen, dass basierend auf der nominalen Spannung der Stromleitung eine Durchbruchspannung ermittelt oder abgeschätzt wird.

In einer Ausführungsform ist vorgesehen, dass basierend auf der ermittelten Durchbruchspannung oder basierend auf der abgeschätzten Durchbruchspannung eine Größe oder eine Schwere des Defekts in der Isolierung der Stromleitung bestimmt wird.

Die Durchbruchspannung (U_Durchbruch) bestimmt sich dann über:

$$U\_Durchbruch = U\_max * Sin(Phase\_Corona)$$
$$= U\_max * Sin(2 * Pi * t\_Corona * Netzfrequenz),$$

wobei U max die nominale Spannung ist.

So ist es in vorteilhafter Weise möglich, erkannte Defektstellen für eine spätere Reparatur zu priorisieren.

Diese funktionale Bewertung von Defekten ist zum Beispiel in der in der Beschreibungseinleitung genannten Stand der Technik gemäß DE 10 2015 221 600 A1 nicht möglich.

Im realen Messbetrieb kommt es bei Hochspannungsleitungen regelmäßig vor, dass auch zwischen den Leitungen über die Luft quasi dauerhaft Entladungen stattfinden. Diese stellen - zumeist sogar abhängig von der Luftfeuchtigkeit, weil diese mit der Isolationsfähigkeit der Luft invers korreliert - eine Grundpegel Schall dar. Eine Corona offenbart sich dann, wenn zu einer bestimmten Zeit ab Nulldurchgang der Phase der Wechselspannung dann ein größeres und auch zeitlich im Messsignal lokalisierteres Signal vorkommt.

In einer Ausführungsform ist vorgesehen, dass bestimmt wird, dass basierend auf dem akustischen Signal ein Durchbruch oder eine Corona detektiert wurde, wenn eine Intensität des akustischen Signals größer oder größer-gleich einem vorbestimmten akustischen Schwellwert ist.

In einer Ausführungsform sind mehrere akustische Sensoren vorgesehen, wobei diese in einer bekannten Geometrie angeordnet sind.

In einer Ausführungsform wird basierend auf der bekannten Geometrie und den jeweiligen gemessenen akustischen Signalen eine Triangulation durchgeführt, um einen Ort der Quelle der akustischen Signale zu ermitteln.

Bei einer angenommenen Schallgeschwindigkeit von ca. 300 m/s kann hier mit einer hinreichend genauen zeitlichen Auflösung gemessen werden. Bei einer Zeitauflösung von 1 ms lässt sich der Ort auf ca. 0,3 m genau bestimmen, bei 10 μs Auflösung dann auf 3 mm. Damit lässt sich dann sogar in vorteilhafter Weise bestimmen, welche Leitung in einem Leitungsbündel von einem Defekt betroffen ist, was ein Magnetfeldsensor so alleine nicht kann.

In einer Ausführungsform ist vorgesehen, die akustischen Signale mit den magnetischen Signalen zu referenzieren oder zu korrelieren, um so mögliche Fehldetektionen zu vermeiden.

Für die Messung einer Durchbruchspannung werden insbesondere nur solche akustischen Signale verwendet oder berücksichtigt, die in einem ansteigenden Bereich der Wechselspannung erkannt oder detektiert werden. Wenn es sich um einen Defekt handelt, sollte das Signal ja in jeder vollen Periode der Spannung erkannt werden. Die Signale von positiver und negativer Halbwelle können unterschiedlich sein im Zeitpunkt des Auftretens. Auch diese Asymmetrie kann als Charakteristik für den Defekt ausgewertet werden.

Die Koinzidenz von Schallsignal und magnetischer Phasenlage kann als eine zwei-phasige Messung ausgeführt sein. Diese zwei-phasige Messung wird verwendet, um einerseits genauer zu messen und zudem Fehlmessung sicher(er) zu detektieren.

Generell ist es wichtig bzw. vorteilhaft und so auch gemäß einer Ausführungsform vorgesehen, dass es möglichst keine Einkopplung von einer Steuerungs- und Antriebstechnik der Inspektionsvorrichtung in die Messsensorik (akustischer Sensor, Magnetfeldsensor, Kamera) gibt. Die Einkopplung kann auf verschiedene Arten optimiert und/oder minimiert werden.

Eine Ausführungsform sieht vor, die einzelnen kritischen Elemente im interessierenden Frequenzbereich entsprechend abzuschirmen. Zum Beispiel weisen die Antriebstechnik und/oder die Steuerungstechnik keine elektrischen Signale im Bereich der Netzfrequenz und ihrer Oberwellen auf. Dann können insbesondere die Messsignale mit einem Bandpass für die Netzfrequenz passend gefiltert werden. Alterativ oder ergänzend ist die Steuerungstechnik derart ausgelegt, dass in der Steuerung die Netzfrequenz samt der Oberwellen nicht verwendet werden und so in diesem Frequenzbereich kein Störsignal erzeugt wird. Entsprechendes gilt auch für eine Antriebstechnik, welche zum Beispiel eine Ansteuerung eines oder mehrerer Antriebe umfassen kann. So kann zum Beispiel bei einem Luftfahrzeug umfassend einen oder mehrere Propeller vorgesehen, dass dieser mit zur Netzfrequenz und Oberwellen verschiedenen Frequenzen angetrieben werden.

Eine Stromleitung im Sinne der Beschreibung kann ummantelt sein oder kann nicht ummantelt sein, also kann frei von einer Ummantelung sein.

Eine Isolierung kann zum Beispiel als eine Ummantelung um die Stromleitung gebildet sein.

Eine Isolierung kann zum Beispiel einen Isolator an einem Strommast umfassen oder kann als ein solcher Isolator gebildet sein, wobei die Stromleitung an dem Strommast befestigt ist.

Ein Defekt an einer Isolierung der Stromleitung kann also zum Beispiel ein Defekt an dem Isolator und/oder an der Ummantelung sein.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei

FIG 1 ein Ablaufdiagramm eines Verfahrens zum Überwachen einer einen elektrischen Strom führenden Stromleitung gemäß einer ersten Ausführungsform,

FIG 2 ein Verfahren zum Überwachen einer einen elektrischen Strom führenden Stromleitung gemäß einer zweiten Ausführungsform,

FIG 3 eine mobile Inspektionsvorrichtung gemäß einer ersten Ausführungsform,

FIG 4 ein maschinenlesbares Speichermedium und

FIG 5 eine mobile Inspektionsvorrichtung gemäß einer zweiten Ausführungsform

zeigen.

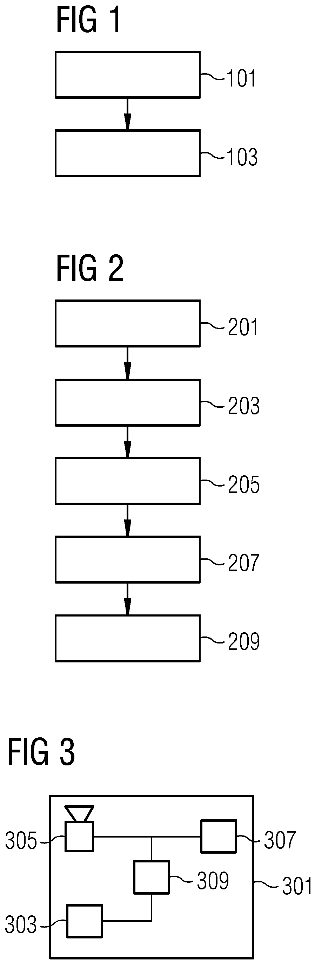

FIG 1 zeigt ein Ablaufdiagramm eines Verfahrens zum Überwachen einer einen elektrischen Strom führenden Stromleitung gemäß einer ersten Ausführungsform.

Das Verfahren wird unter Verwendung einer mobilen Inspektionsvorrichtung durchgeführt. Die mobile Inspektionsvorrichtung umfasst einen Magnetfeldsensor und eine Kamera.

Das Verfahren umfasst die folgenden Schritte:

Messen 101 eines durch den Strom erzeugten Magnetfelds mittels des Magnetfeldsensors und

Aufnehmen 103 eines Bildes der Stromleitung mittels der Kamera in Abhängigkeit des gemessenen Magnetfelds.

FIG 2 zeigt ein Ablaufdiagramm eines Verfahrens zum Überwachen einer einen elektrischen Strom führenden Stromleitung gemäß einer zweiten Ausführungsform.

Das Verfahren wird unter Verwendung einer mobilen Inspektionsvorrichtung durchgeführt. Die mobile Inspektionsvorrichtung umfasst einen Magnetfeldsensor, eine Kamera und einen akustischen Sensor, mittels welchem ein Luftschall gemessen werden kann.

Das Verfahren umfasst ein Messen 201 eines durch den Strom erzeugten Magnetfelds mittels des Magnetfeldsensors.

Das Verfahren umfasst weiter ein Ermitteln 203 einer Phase und einer Frequenz des elektrischen Stroms basierend auf dem gemessenen Magnetfeld.

Das Verfahren umfasst ein Messen 205 eines Luftschalls mittels des akustischen Sensors.

Das Verfahren umfasst ein Auswerten 207 des gemessenen Luftschalls basierend auf der ermittelten Phase und der ermittelten Frequenz, um ein aus einem Spannungsüberschlag resultierendes akustisches Signal zu detektieren.

Das Verfahren umfasst ein Aufnehmen 209 eines Bildes der Stromleitung mittels der Kamera in Abhängigkeit des gemessenen Magnetfelds.

FIG 3 zeigt eine mobile Inspektionsvorrichtung 301 zum Überwachen einer einen elektrischen Strom führenden Stromleitung.

Die mobile Inspektionsvorrichtung 301 umfasst einen Magnetfeldsensor 303, welcher eingerichtet ist, einen durch den Strom erzeugtes Magnetfeld zu messen.

Die mobile Inspektionsvorrichtung 301 umfasst weiter eine Kamera 305, welche eingerichtet ist, ein Bild der Stromleitung in Abhängigkeit des gemessenen Magnetfelds aufzunehmen.

Die mobile Inspektionsvorrichtung 301 umfasst weiter einen akustischen Sensor 307, welcher eingerichtet ist, einen Luftschall zu erfassen oder zu messen.

**EP 3 899 554 B1**

Die mobile Inspektionsvorrichtung 301 umfasst weiter eine Steuerung 309, welche eingerichtet ist, die mobile Inspektionsvorrichtung 301 zu steuern. Zum Beispiel ist die Steuerung 309 eingerichtet, eine Bewegung der mobilen Inspektionsvorrichtung 301 zu steuern.

Die Steuerungseinrichtung 309 ist z.B. eingerichtet, die mobile Inspektionsvorrichtung 301 basierend auf dem gemessenen Magnetfeld und/oder basierend auf dem aufgenommenen Bild und/oder basierend auf dem gemessenen Luftschall zu steuern.

Zum Beispiel ist die Steuerungseinrichtung 309 eingerichtet, Aufnahmeparameter für die Kamera 303 basierend auf dem gemessenen Magnetfeld zu ermitteln.

Zum Beispiel ist die Steuerungseinrichtung 309 eingerichtet, die Kamera 303 basierend auf den ermittelten Aufnahmeparametern zu steuern, um ein Bild der Stromleitung aufzunehmen.

Aufnahmeparameter umfassen z.B.: eine Belichtungszeit und/oder einen Triggerzeitpunkt.

Die Steuerungseinrichtung 309 ist z.B. eingerichtet, ein oder mehrere Schritte des Verfahrens gemäß dem ersten Aspekt auszuführen oder zu steuern.

Die mobile Inspektionsvorrichtung 301 ist gemäß einer Ausführungsform ein Luftfahrzeug, beispielsweise eine Drohne, beispielsweise ein Quadrocopter. In einem solchen Fall ist die Steuerungseinrichtung 309 z.B. eine Flugsteuerungseinrichtung.

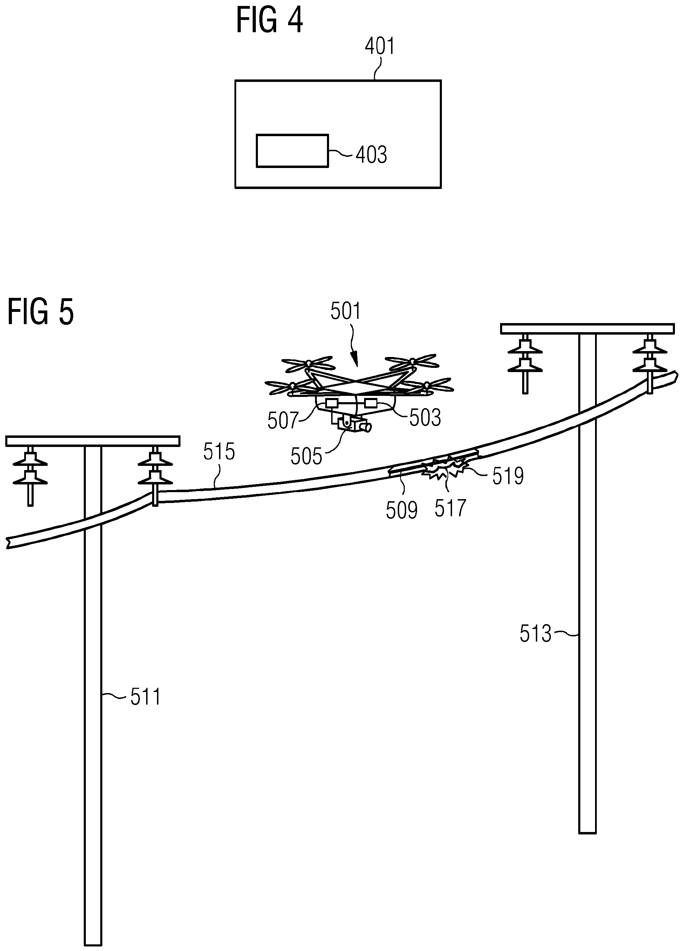

FIG 4 zeigt ein maschinenlesbares Speichermedium 401.

Auf dem maschinenlesbaren Speichermedium 401 ist ein Computerprogramm 403 gespeichert. Das Computerprogramm 403 umfasst Befehle, die bei Ausführung des Computerprogramms 403 durch einen Computer, beispielsweise durch die Steuerungseinrichtung 309 der mobilen Inspektionsvorrichtung 301 gemäß FIG 3, diesen veranlassen, ein Verfahren gemäß dem ersten Aspekt auszuführen.

FIG 5 zeigt eine mobile Inspektionsvorrichtung 501 gemäß einer zweiten Ausführungsform, wobei die mobile Inspektionsvorrichtung 501 als eine Drohne gebildet ist.

Die Drohne 501 umfasst einen Magnetfeldsensor 503, eine Kamera 505, und eine Steuerungseinrichtung 507. Die Steuerungseinrichtung 507 ist als eine Flugsteuerungseinrichtung ausgebildet. Das heißt also, dass die Steuerungseinrichtung 507 einen Flug der Drohne 501 steuern kann.

Die Drohne 501 überwacht eine einen elektrischen Strom führende Stromleitung 509, welche eine Isolierung 515 umfasst. Der elektrische Strom, welcher durch die Stromleitung 509 fließt, ist ein Wechselstrom.

Die Stromleitung 509 verläuft zwischen einem ersten Strommast 511 und einem zweiten Strommast 513, wobei die Stromleitung 509 an dem ersten Strommast 511 und an dem zweiten Strommast 513 befestigt ist.

Die Isolierung 515 umfasst einen Defekt 517, an welchem Spannungsdurchbrüche oder Spannungsüberschläge auftreten können. Dieser Spannungsüberschlag ist durch einen Lichtblitz 519 begleitet, welcher auch als eine Corona bezeichnet werden kann.

Der Magnetfeldsensor 505 misst ein durch den elektrischen Strom erzeugtes Magnetfeld, sodass hierüber eine Phase und eine Frequenz des elektrischen Stroms ermittelt werden können.

Somit kann abgeschätzt werden, wann an welchem Ort mit einem Lichtblitz gerechnet werden kann, sofern an der entsprechenden Stelle der Stromleitung 509 in der Isolierung 515 ein Defekt vorhanden ist.

Somit kann in effizienter Weise die Kamera 503 derart betrieben werden, dass sie zum ermittelten Zeitpunkt ein oder mehrere Bilder der Stromleitung 509 aufnimmt.

Weiter kann z.B. die Steuerungseinrichtung 507 die Drohne 501 derart steuern, dass sie den ermittelten Ort derart ansteuert, dass die Kamera 503 diesen Ort auch erfassen kann.

In einer nicht gezeigten Ausführungsform umfasst die Drohne 501 einen oder mehrere akustische Sensoren zum Messen eines Luftschalls, wie vorstehend beschrieben.

Vorteile des hier beschriebenen Konzepts sind nachfolgend weiter erläutert:

Aus der Messung mit dem(n) Zusatzsensor(en) (Magnetfeldsensor und optional akustischer Sensor) kann

> a) mehr Information über das Messobjekt, hier die Stromleitung, gewonnen werden, kann
>
> b) die Messungen erstmals auch mit dem Funktionszustand des Messobjektes gekoppelt werden, um so auch nicht nur geometrische Messungen mit erhöhter Präzision vorzunehmen, sondern auch funktionale Bewertungen vornehmen zu können, kann
>
> c) aufgrund der Messsignale der Zusatzsensoren das Messobjekt selber getrackt und von der Inspektionsvorrichtung verfolgt werden und nicht nur statische Routen auf Basis von z.B. vorbestimmten GPS Koordinaten verfolgt werden.

Ein Beispiel ist die sichere Erfassung von Corona-Effekten auch auf der von der Kamera abgewandten Seite bei einer Verwendung eines Schallsensors (akustischer Sensor), welcher akustisch einen Spannungsüberschlag detektieren kann, wobei dann z.B. eine Koinzidenz von akustischem und magnetischem Signal ausgenutzt wird und/oder wobei das Schallsignal auf eine quasi-Periodizität mit der Netzfrequenz oder gar der doppelten Netzfrequenz geprüft wird, um das gemessene Schallsignal dahingehend zu überprüfen, ob ein Spannungsüberschlag die Quelle für das Schallsignal ist oder nicht. Das kann z.B. mit einer fortlaufend durchgeführten Fouriertransformation erfolgen, die dann bei den entsprechenden Frequenzen jeweils ein Maximum aufweist.

Durch die Multi-Modale Messung (mehrere unterschiedliche Sensoren) wird die Messung sicherer, z.B. mit dem Ansatz einer zwei-phasigen Messung. Mehr Modalitäten gewinnen meist zusätzliche Daten oder genauere Daten in Bezug auf mindestens ein Merkmal, hier insbesondere die Detektion eines Defekts in der Isolierung.

Die Erfassung des Funktionszustands (Phase und Frequenz des elektrischen Stroms) wird mittels des Magnetfeldsensors durchgeführt. Dies kann bei bestimmten Wetterlagen auch basierend auf einer akustischen Messung mittels des akustischen Sensors durchgeführt werden, um ein Netzbrummen zu detektieren.

Ferner kann die akustische Messung im Vergleich zur Kameramessung auch Defekte an Isolatorbauteilen (allgemein: Isolierung) erfassen, die von der Kamera gesehen auf der Rückseite des Bauteils liegen. Zum Beispiel ist der Schallsensor auf Aspekte der Funktion empfindlich, da er die Schallsignale auffangen kann, die z.B. bei einem Isolationsfehler mit Entladung passieren können. Die Verifikation des Schallsignals kann über die Funktion der Leitung abgesichert werden, da man - a priori - auch weiß, dass Entladungen nur bei höheren Spannungen auftreten.

Allgemein kann also durch die multi-modale Detektion zusammen mit der Ankopplung an die Funktionsparameter des Messobjektes die Detektionsfähigkeit des Messsystems gesteigert oder gar grundlegend erweitert werden.

Konkret für die Applikation der Überwachung einer Stromleitung mit Detektion von Defekten können neue Anwendungen angeboten werden, wie z.B.:

Ortung der Stromleitung im Raum.

Bestimmung des Abstands zwischen der Inspektionsvorrichtung oder dem entsprechenden Sensor zur Stromleitung oder zu einem Teil der Stromleitung.

Erkennung, welche Stromleitung bzw. welches Bündel von Leitern der Stromleitungen in welcher Phasenlage ist.

Zuordnung einer Corona zu einer Stromleitung bzw. einem Isolator, der die Stromleitung trägt.

Verbesserung von Signal-/Rauschabstand der Messungen durch Anpassung der Messzeitpunkte auf den Funktionszustand des Messobjektes (im Sinne eines Lock-In Prinzips aus der Messtechnik), also zum Beispiel Aufnehmen eines Bildes eines Ortes der Stromleitung, während an diesem Ort eine Phase des elektrischen Stroms ein Maximum durchläuft.

Obwohl die Erfindung im Detail durch die bevorzugten Ausführungsbeispiele näher illustriert und beschrieben wurde, so ist die Erfindung nicht durch die offenbarten Beispiele eingeschränkt.

## Patentansprüche

1.  Verfahren zum Überwachen einer einen elektrischen Strom führenden Stromleitung (509) unter Verwendung einer mobilen Inspektionsvorrichtung (301, 501), wobei die mobile Inspektionsvorrichtung (301, 501) einen Magnetfeldsensor (303, 503) und eine Kamera (305, 505) umfasst, umfassend die folgenden Schritte:

    Messen (101, 201) eines durch den Strom erzeugten Magnetfelds mittels des Magnetfeldsensors (303, 503) und Aufnehmen eines Bildes (103, 209) der Stromleitung (509) mittels der Kamera (305, 505) in Abhängigkeit des gemessenen Magnetfelds,
    wobei der elektrische Strom ein Wechselstrom ist, **dadurch gekennzeichnet, dass** basierend auf dem gemessenen Magnetfeld eine Phase und/oder eine Frequenz des elektrischen Stroms ermittelt (203) wird, wobei die Kamera (305, 505) das Bild basierend auf der ermittelten Phase und/oder der ermittelten Frequenz aufnimmt.

2.  Verfahren nach Anspruch 1, wobei das Aufnehmen eines Bildes ein Mehrfachbelichten eines Frames umfasst.

3.  Verfahren nach Anspruch 1 oder 2, wobei das Aufnehmen ein Belichten mehrerer individueller Frames umfasst, welche addiert werden.

4.  Verfahren nach Anspruch 3, wobei die mehreren Frames zur Addition zueinander verschoben werden, um eine Bewegung der mobilen Inspektionsvorrichtung (301, 501) auszugleichen.

5.  Verfahren nach einem der vorherigen Ansprüche, wobei für das Aufnehmen des Bildes nur ein bestimmter Teilbereich eines Bildsensors der Kamera (305, 505) in Abhängigkeit einer Ausrichtung des Magnetfeldsensors (303, 503) relativ zur Stromleitung (509) ausgelesen wird.

6.  Verfahren nach einem der Ansprüche 1 bis 5, wobei die mobile Inspektionsvorrichtung zumindest einen akustischen Sensor (307) umfasst, mittels welchem ein Luftschall gemessen (205) wird, wobei der gemessene Luftschall basierend auf der ermittelten Phase und/oder der ermittelten Frequenz ausgewertet (207) wird, um ein aus einem Spannungsüberschlag resultierendes akustisches Signal zu detektieren.

7. Verfahren nach Anspruch 6, wobei mehrere akustische Sensoren (307) vorgesehen sind, wobei basierend auf dem jeweiligen gemessenen Luftschall eine Triangulation durchgeführt wird, um eine Quelle des akustischen Signals zu orten.

8. Verfahren nach Anspruch 6 oder 7, wobei eine Phasenlage des elektrischen Stroms zum Zeitpunkt des detektierten Spannungsüberschlags ermittelt wird, wobei basierend auf der ermittelten Phasenlage und einer Nominalspannung der Stromleitung (509) eine Durchbruchspannung ermittelt wird.

9. Verfahren nach einem der vorherigen Ansprüche, wobei das aufgenommene Bild ausgewertet wird, um einen Spannungsüberschlag zu detektieren, wobei bei Detektion eines Spannungsüberschlags die mobile Inspektionsvorrichtung (301, 501) und/oder die Kamera (305, 505) derart gesteuert werden, dass ein Ort einer Quelle des detektierten Spannungsüberschlags weiter mittels der Kamera (305, 505) aufgenommen werden kann.

10. Verfahren nach einem der vorherigen Ansprüche, wobei basierend auf dem gemessenen Magnetfeld Steuersignale zum Steuern einer Bewegung der mobilen Inspektionsvorrichtung (301, 501) erzeugt und ausgegeben werden, um die mobile Inspektionsvorrichtung (301, 501) entlang eines Verlaufs der Stromleitung (509) zu bewegen.

11. Mobile Inspektionsvorrichtung (301, 501) eingerichtet zum Überwachen einer einen elektrischen Strom führenden Stromleitung (509), umfassend:

   einen Magnetfeldsensor (303, 503), welcher eingerichtet ist, ein durch den Strom erzeugtes Magnetfeld zu messen, und
   eine Kamera (305, 505), welche eingerichtet ist, ein Bild der Stromleitung (509) in Abhängigkeit des gemessenen Magnetfelds aufzunehmen,
   wobei der elektrische Strom ein Wechselstrom ist, **dadurch gekennzeichnet, dass** basierend auf dem gemessenen Magnetfeld eine Phase und/oder eine Frequenz des elektrischen Stroms ermittelt (203) wird, wobei die Kamera (305, 505) das Bild basierend auf der ermittelten Phase und/oder der ermittelten Frequenz aufnimmt.

12. Computerprogramm (403), umfassend Befehle, die bewirken, dass die mobile Inspektionsvorrichtung (301,501) des Anspruchs 11 ein Verfahren gemäß einem der Ansprüche 1 bis 10 ausführt.

13. Maschinenlesbares Speichermedium (401), auf dem das Computerprogramm (403) nach Anspruch 12 gespeichert ist.

**Claims**

1. Method for monitoring a power line (509) that carries an electric current, using a mobile inspection device (301, 501), wherein the mobile inspection device (301, 501) comprises a magnetic field sensor (303, 503) and a camera (305, 505), said method comprising the following steps:

   measuring (101, 201) a magnetic field produced by the current, by means of the magnetic field sensor (303, 503), and
   capturing an image (103, 209) of the power line (509) by means of the camera (305, 505) on the basis of the measured magnetic field,
   wherein the electric current is an alternating current, **characterized in that** a phase and/or a frequency of the electric current is identified (203) based on the measured magnetic field, the camera (305, 505) capturing the image based on the identified phase and/or the identified frequency.

2. Method according to Claim 1, wherein the capture of an image comprises multiple exposure of a frame.

3. Method according to Claim 1 or 2, wherein the capture comprises exposure of multiple individual frames, which are added together.

4. Method according to Claim 3, wherein the multiple frames are shifted with respect to one another for the addition in order to compensate for a movement of the mobile inspection device (301, 501).

5. Method according to one of the preceding claims, wherein, to capture the image, only a specific subregion of an image sensor of the camera (305, 505) is read on the basis of an alignment of the magnetic field sensor (303, 503) relative to the power line (509).

6. Method according to one of Claims 1 to 5, wherein the mobile inspection device comprises at least one acoustic sensor (307), by means of which an airborne sound is measured (205), the measured airborne sound being evaluated (207) on the basis of the identified phase and/or the identified frequency in order to detect an acoustic signal resulting from a voltage flashover.

7. Method according to Claim 6, wherein there is provision for multiple acoustic sensors (307), a triangulation being carried out based on the respective measured airborne sound in order to locate a source of the acoustic signal.

8. Method according to Claim 6 or 7, wherein a phase angle of the electric current at the time of the detected voltage flashover is identified, a breakdown voltage being identified based on the identified phase angle and a nominal voltage of the power line (509).

9. Method according to one of the preceding claims, wherein the captured image is evaluated in order to detect a voltage flashover, detection of a voltage flashover resulting in the mobile inspection device (301, 501) and/or the camera (305, 505) being controlled in such a way that a location of a source of the detected voltage flashover can further be captured by means of the camera (305, 505).

10. Method according to one of the preceding claims, wherein control signals for controlling a movement of the mobile inspection device (301, 501) are generated and output based on the measured magnetic field in order to move the mobile inspection device (301, 501) along a run of the power line (509) .

11. Mobile inspection device (301, 501) configured to monitor a power line (509) that carries an electric current, comprising:

   a magnetic field sensor (303, 503), which is configured to measure a magnetic field produced by the current, and a camera (305, 505), which is configured to capture an image of the power line (509) on the basis of the measured magnetic field,
   wherein the electric current is an alternating current, **characterized in that** a phase and/or a frequency of the electric current is identified (203) based on the measured magnetic field, the camera (305, 505) capturing the image based on the identified phase and/or the identified frequency.

12. Computer program (403), comprising commands that prompt the mobile inspection device (301, 501) of Claim 11 to perform a method according to one of Claims 1 to 10.

13. Machine-readable storage medium (401), on which the computer program (403) according to Claim 12 is stored.

**Revendications**

1. Procédé de contrôle d'une ligne (509) de courant conduisant un courant électrique, en utilisant un dispositif (301, 501) mobile d'inspection, dans lequel le dispositif (301, 501) mobile d'inspection comprend un capteur (303,503) de champ magnétique et une caméra (305, 505), comprenant les stades suivants :

   on mesure (101, 201), au moyen du capteur (303, 503) de champ magnétique, un champ magnétique produit par le courant, et
   on enregistre une image (103, 209) de la ligne (509) de courant, au moyen de la caméra (305, 505) en fonction du champ magnétique mesuré,
   dans lequel le courant électrique est un courant alternatif, **caractérisé en ce que**
   sur la base du champ magnétique mesuré, on détermine (203) une phase et/ou une fréquence du courant électrique, dans lequel la caméra (305, 505) enregistre l'image sur la base de la phase déterminée et/ou de la fréquence déterminée.

**2.** Procédé suivant la revendication 1, dans lequel l'enregistrement d'une image comprend la surimpression d'une frame.

**3.** Procédé suivant la revendication 1 ou 2, dans lequel l'enregistrement comprend l'exposition de plusieurs frames individuelles, que l'on additionne.

**4.** Procédé suivant la revendication 3, dans lequel on décale plusieurs frames les unes par rapport aux autres pour l'addition, afin de compenser un déplacement du dispositif (301, 501) mobile d'inspection.

**5.** Procédé suivant l'une des revendications précédentes, dans lequel pour l'enregistrement de l'image, on ne lit qu'une partie partielle déterminée d'un capteur d'images de la caméra (305,505) en fonction d'une orientation du capteur (303, 503) de champ magnétique par rapport à la ligne (509) de courant.

**6.** Procédé suivant l'une des revendications 1 à 5, dans lequel le dispositif mobile d'inspection comprend au moins un capteur (307) acoustique, au moyen duquel on mesure (205) un son aérien, dans lequel on analyse (207) le son aérien mesuré sur la base de la phase déterminée et/ou de la fréquence déterminée, afin de détecter un signal acoustique provenant d'une décharge de tension.

**7.** Procédé suivant la revendication 6, dans lequel il est prévu plusieurs capteurs (307) acoustiques, dans lequel on effectue une triangulation sur la base du son aérien respectif mesuré, afin de localiser une source du signal acoustique.

**8.** Procédé suivant la revendication 6 ou 7, dans lequel on détermine une position en phase du courant électrique à l'instant de la détection de la surcharge de tension, dans lequel on détermine une tension de claquage sur la base de la position en phase déterminée et d'une tension nominale de la ligne (509) de courant.

**9.** Procédé suivant l'une des revendications précédentes, dans lequel on analyse l'image enregistrée afin de détecter une surcharge de tension, dans lequel, lors de la détection d'une surcharge de tension, on commande le dispositif (301, 501) mobile d'inspection et/ou la caméra (305, 505) de manière à pouvoir continuer à enregistrer au moyen de la caméra (305, 505) un emplacement d'une source de la surcharge de tension détectée.

**10.** Procédé suivant l'une des revendications précédentes, dans lequel, sur la base du champ magnétique mesuré, on produit et on émet des signaux de commande pour la commande d'un déplacement du dispositif (301, 501) mobile d'inspection, afin de déplacer le dispositif (301, 501) d'inspection le long d'un tracé de la ligne (509) de courant.

**11.** Dispositif (301, 501) mobile d'inspection agencé pour contrôler une ligne (509) de courant conduisant à un courant électrique, comprenant :

un capteur (303, 503) de champ magnétique, qui est agencé pour mesurer un champ magnétique produit par le courant, et une caméra (305, 505), qui est agencée pour enregistrer une image de la ligne (509) de courant en fonction du champ magnétique mesuré,
dans lequel le courant électrique est un courant alternatif, **caractérisé en ce que**
sur la base du champ magnétique mesuré, on détermine (203) une phase et/ou une fréquence du courant électrique, dans lequel la caméra (305, 505) enregistre l'image sur la base de la phase déterminée et/ou de la fréquence déterminée.

**12.** Programme (403) d'ordinateur, comprenant des instructions, qui font que le dispositif (301, 501) mobile d'inspection de la revendication 11 exécute un procédé suivant l'une des revendications 1 à 10.

**13.** Support (401) de mémoire, déchiffrable par machine, sur lequel le programme (403) d'ordinateur de la revendication 12 est mis en mémoire.

## FIG 1

```
┌─────────────────────┐
│                     │ ～101
└─────────────────────┘
          │
          ▼
┌─────────────────────┐
│                     │ ～103
└─────────────────────┘
```

## FIG 2

```
┌─────────────────────┐
│                     │ ～201
└─────────────────────┘
          │
          ▼
┌─────────────────────┐
│                     │ ～203
└─────────────────────┘
          │
          ▼
┌─────────────────────┐
│                     │ ～205
└─────────────────────┘
          │
          ▼
┌─────────────────────┐
│                     │ ～207
└─────────────────────┘
          │
          ▼
┌─────────────────────┐
│                     │ ～209
└─────────────────────┘
```

## FIG 3

## FIG 4

## FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20150225002 A1
- US 20150353196 A1
- EP 2495166 A1
- DE 102015221600 A1